(19) Europäisches Patentamt
European Patent Office
Office européen des brevets

(11) EP 1 868 419 A1

(12) EUROPEAN PATENT APPLICATION
published in accordance with Art. 158(3) EPC

(43) Date of publication:
**19.12.2007 Bulletin 2007/51**

(21) Application number: **06729006.4**

(22) Date of filing: **14.03.2006**

(51) Int Cl.:
***H05B 33/00*** *(2006.01)*

(86) International application number:
**PCT/JP2006/304941**

(87) International publication number:
**WO 2006/103907 (05.10.2006 Gazette 2006/40)**

(84) Designated Contracting States:
**DE FR GB**

(30) Priority: **29.03.2005 JP 2005093909**

(71) Applicant: **IDEMITSU KOSAN CO., LTD.**
**Tokyo 100-8321 (JP)**

(72) Inventors:
- **KATANO, Junichi**
**Chiba, 2990293 (JP)**
- **HACHIYA, Satoshi**
**Chiba, 2990293 (JP)**
- **HOSOKAWA, Chishio**
**Chiba, 2990293 (JP)**

(74) Representative: **Gille, Christian**
**Gille Hrabal Struck Neidlein Prop Roos**
**Brucknerstrasse 20**
**40593 Düsseldorf (DE)**

(54) **RED FLUORESCENCE CONVERSION MEDIUM, COLOR CONVERSION SUBSTRATE USING SAME, AND LIGHT-EMITTING DEVICE**

(57) A red fluorescence conversion medium including; a light-transmitting medium, a first perylene fluorescent dye that emits red fluorescence, and a second fluorescent dye that absorbs light in a ultraviolet to blue region to emit fluorescence, wherein the first perylene fluorescent dye absorbs light containing the fluorescence emitted by the second fluorescent dye to emit fluorescence.

EP 1 868 419 A1

## Description

TECHNICAL FIELD

The invention relates to a red fluorescence conversion medium, and a color conversion substrate and light-emitting apparatus using the red fluorescence conversion medium.

BACKGROUND

A color conversion substrate which converts the wavelength of light emitted from a light source using a fluorescent material has been applied in various fields such as the electronic display field.
For example, an organic luminescent device (EL device) and a fluorescence conversion film are arranged in the stacking direction to variously change the color of emitted light (Patent documents 1 and 2, for example).
Patent document 2 uses light emitted from an organic EL device unchanged as blue (B) of three primary colors (R, G, B) required for full-color display. In this case, the blue conversion efficiency may be said to be 100%. For green (G), its conversion efficiency is 80% by using coumarin 153.
When a fluorescence conversion film formed of phenoxazon 9 and a color-adjusting filter are arranged, red light with chromaticity x=0.62, y=0.33 is obtained.
However the converted light is too weak to be seen in bright places. The conversion efficiency is extremely low.
For red fluorescence conversion film technology, it is disclosed that two types of color converting dyes are used to enhance a conversion efficiency and color purity (Patent document 3, for example).
However, the technology uses rhodamine dyes which are easily influenced by circumstances. In particular, if a fluorescent dye is dispersed in a liquid resist, the decolorization of fluorescent dye and quenching occur by radicals and ions generated from photoinitiators and cross-linking agents (photoreactive multifunctional monomers) in the resist in an exposure or heating (postbake) process of photolithography (Patent document 4, for example).
In addition, the film disadvantageously deteriorates (due to light irradiation for a long time) when a display using the film is lighted for a long time.
It is known that a fluorescence conversion medium using a perylene fluorescent dye excellent in durability converts blue light of a LED to white light (Non-patent document 1, for example).
The technology is also known which uses a perylene fluorescent dye excellent in durability to obtain white light (Non-pantent document 2, for example).
However, in these technologies, short-wavelength light components pass through, leading to difficulity in efficient red conversion.
Further, in these technologies, entire emission region of a light source of short-wavelength components to excite a fluorescence conversion medium is covered with a fluorescence conversion medium. Even if light of short-wavelength components and fluorescence from a perylene dye are mixed to produce white light, part of the light of short-wavelength components is inevitably absorbed in the perylene dye in a fluorescence medium and thus strong light of short-wavelength components cannot be effectively used. It is then difficult to obtain white light with a good luminous efficiency.
Further, light of short-wavelength components transmitted through a fluorescence conversion medium and fluorescence emitted from the fluorescence medium are influenced by a dye concentration in the fluorescence conversion medium and the medium thickness. Thus it is difficult to design a fluorescence conversion medium to obtain white light having various color temperatures and color rendering indices (Ra).
As stated above, conventional fluorescence conversion mediums converting ultraviolet to blue light from a light source to red light with a high efficiency and a high purity do not have a high durability. Further since light in the blue region is not sufficiently absorbed, blue light from an exciting-light source is mixed with red light of fluorescence to reduce a color purity. The blue light can be removed with a color filter e.t.c. to obtain highly pure red light. However the highly pure red light cannot be obtained with a high efficiency since the color filter wastefully absorbs energy.
White light with a high efficiency cannot also be easily obtained.

[Patent document 1] JP-B-63-18319
[Patent document 2] JP-A-H3-152897
[Patent document 3] WO97/29163 pamphlet
[Patent document 4] JP-A-H7-268010
[Non-patent document 1]Materials Science and Engineering, B59, 390(1999)
[Non-patent document 2]Appl. Phys. Lett. 80, 3470(2002)

As stated above, the conventional red fluorescence conversion mediums have a low durability. Their light

deteriorates in color quality or becomes dark with lighting time. Perylene dyes are known for very long duablity but no perylene dyes are known which efficiently convert blue light from a light source to red light.
In view of the above problems, an object of the invention is to provide a red fluorescence conversion medium with a high converting efficiency and durability.
Another object of the invention is to provide a fluorescence medium which gives white light with a high efficiency easily.

SUMMARY OF THE INVENTION

The inventors have found that the use of dyes of two or more types, a high durable perylene dye and another fluorescent dye, in combination enables to use ultraviolet to blue light from a source efficiently, enhancing a red conversion efficiency. The invention has been completed based on the finding.
The invention provides the following red fluorescence conversion medium, and color conversion substrate and light-emitting apparatus using the medium.

1. A red fluorescence conversion medium comprising; a light-transmitting medium,
a first perylene fluorescent dye that emits red fluorescence, and
a second fluorescent dye that absorbs light in a ultraviolet to blue region and emits fluorescence,
wherein the first perylene fluorescent dye absorbs light containing the fluorescence emitted by the second fluorescent dye and emits fluorescence.
2. The red fluorescence conversion medium according to 1, further comrising a third fluorescent dye of which the absorption edge of light is a longer wavelength than the absorption edge of light of the second fluorescent dye, wherein the second fluorescent dye and/or the third fluorescent dye are/is a perylene fluorescent dye.
3. The red fluorescence conversion medium according to 1 or 2, wherein a relationship between a maxium value of an optical density OD1 in a wavelength region of 600 nm to 700 nm, and a maxium value of an optical density OD2 in a wavelength region of 400 nm to 500 nm is OD2/OD1 > 1.5.
4. The red fluorescence conversion medium according to any one of 1 to 3, further comprising a light-scatteirng material.
5. A color conversion substrate comprising the red conversion fluorescence medium according to any one of 1 to 4 on a transparent substrate.
6. The color conversion substrate according to 5, further comprising a green fluorescence medium.
7. A light-emitting apparatus comprising the red fluorescence conversion medium according to any one of 1 to 4 and an exciting-light source,
wherein light emitted from the exciting-light source has one or more emission peaks in a wavelength region of 400 nm to 500 nm.
8. The light-emitting apparatus according to 7, wherein fluorescence emitted from the red fluorescence conversion medium and light emitted from the exciting-light source are mixed to emit white light.
9. The light-emitting apparatus according to 7 or 8, wherein the exciting-light source is a light source converting electric energy to light.
10. The light-emitting apparatus according to 7 or 8, wherein the exciting-light source is natural light.
11. A light-emitting apparatus comprising the exciting-light source and the color conversion substrate according to 5 or 6.

The red fluorescence conversion medium of the invention has a high conversion efficiency and color purity, and excellent durability. Accordingly products can be easily obtained by using the medium which are very bright and exhibit small changes in color and brightness with time in applications selecting and using long-wavelength components from light containing short-wavelength components emitted by a light source, e.g. LEDs, organic EL displays and illuminations.

BRIEF DESCRIPTION OF DRAWINGS

FIG. 1 is a schematic view for explaining the color-conversion mechanism of the red fluorescence conversion medium according to the invention.
FIG. 2 is a schematic sectional view showing an embodiment of the white-light-emitting apparatus according to the invention.
FIG. 3 shows the optical density (OD) spectra of red fluorescence conversion media of Example 1 and Comparative Example 2.

FIG. 4 is a view showing the relationship between an irradiation time of exciting light and amount of change in luminance of Example 1.

FIG. 5 is a view showing the relationship between an irradiation time of exciting light and amount of changes in chromaticity (CIEx) of Example 1.

FIG. 6 is a view showing the relationship between an irradiation time of exciting light and amount of changes in chromaticity (CIEy) of Example 1.

FIG. 7 shows the optical density (OD) spectra of red fluorescence conversion media of Example 2 and Comparative Example 2.

FIG. 8 shows the optical density (OD) spectra of red fluorescence conversion media of Comparative Example 1.

FIG. 9 is a view showing the relationship between an irradiation time of exciting light and amount of change in luminance of Comparative Example 1.

FIG. 10 is a view showing the relationship between an irradiation time of exciting light and amount of changes in chromaticity (CIEx) of Comparative Example 1.

FIG. 11 is a view showing the relationship between an irradiation time of exciting light and amount of changes in chromaticity (CIEy) of Comparative Example 1.

FIG. 12 shows the emission spectra of a blue LED with a conversion medium and the blue LED only.

FIG. 13 shows the emission spectrum of an organic EL device of Example 7.

FIG. 14 shows the emission spectrum of an organic EL device of Preparation Example 1.

FIG. 15 shows the transmission spectrum of a color filter for chromaticity adjustment of Preparation Example 2.

## BEST MODE FOR CARRYING OUT THE INVENTION

A red fluorescence conversion medium according to the invention is described below in detail.

The red fluorescence conversion medium of the invention comprises (A) a light-transmitting medium, (B) a first perylene fluorescent dye which emits red fluorescence and (C) a second fluorescent dye which absorbs light in a ultraviolet-blue region to emit light having a longer wavelength than that of the absorbed light, the first and second fluorescent dyes being dispersed in the light-transmitting medium.

The red fluorescence conversion medium preferably further comprises (D) a third fluorescent dye of which the absorption edge on the long-wavelength side is a longer wavelength than that of (B) the second fluorescent dye.

The component (B) is a fluorescent dye that receives fluorescence emitted by the component (C) or (D) to emit red fluorescence.

The component (C) is a fluorescent dye that absorbs light in a ultraviolet to blue region to transfer energy to the first or second fluorescent dye of the component (B) or (D).

The component (D) absorbs fluorescence emitted by the component (C) to emit fluorescence with a further longer wavelength, thereby transfering energy to the component (B).

FIG. 1 is a schematic view for explaining color-conversion mechanism of the red fluorescence conversion medium according to the invention.

Light in a ultraviolet to blue region emitted from an exciting-light source (not shown) is mainly absorbed by the second fluorescent dye. The second fluorescent dye then emits fluorescence where energy is shifted to a longer wavelength, e.g., light in a yellow to green region.

Next, the first perylene fluorescent dye absorbs fluorescence emitted by the second fluorescent dye to emit red fluorescence.

At this time, by adding the third fluorescent dye of the component (D), fluorescence (energy) emitted by the component (C) can be transferred through the component (D) to the component (B). This allows more efficient receipt and transfer.

According to the invention, the prompt transfer of energy absorbed by the component (C) and/or component (D) to the component (B) or (C) can suppress energy used in reactions causing degradation of fluorescent dyes. Specifically, dyes other than perylene fluorescent dyes relatively easily deteriorate but the deterioration of such dyes can be suppressed. As a result, there can be obtained a red fluorescence conversion medium that changes to a small degree with time.

Each constituent member of the red fluorescence conversion medium of the invention will be described below.

### (A) Light-transmitting medium

The component (A) may be any one that is light-transmissive and from which a film can be formed. For example, high-molecular-weight compounds, inorganic glass and print media can be used.

The high-molecular-weight compounds include polyvinylpyrrolidinone, polymethylmethacrylate, polymethylacrylate, polystyrene, polycarbonate, polyvinyl acetate, polyvinylchloride, polybutene, polyethyleneglycol and copolymers thereof. Photosensitive resins such as a photoresist and thermosetting resins such as epoxy resins can also be used.

The inorganic glass includes borate glass and silica glass.

Preferable print media include light-transmitting print media obtained by dissolving a polyvinylchloride or polyester resin in a solvent.

When forming a pattern by photolithography, the medium is desirably a monomer and/or oligomer having light-polymerizable ethylene unsaturated group or a transparent resin component containing a binder resin of methacrylate ester-methacrylic acid copolymer and a monomer and/or oligomer having light-polymerizable ethylenically unsaturated group.

In the invention, these light-transmitting media may be used individually or in a combination of two or more. The light-transmitting medium preferably has a light-ray transmitance in a visible light range of 60% or more, particularly preferably 90% or more.

(B) First perylene fluorescent dye

The component (B) is a compound having a perylene ring in its structure and emitting red fluorescence. The red fluorescence means light having red to reddish orange color and wavelengths of 580 nm to 700 nm.

The component (B) is preferably ones which have a high light-converting efficiency and of which the overlap of excitation spectrum and fluorescence spectrum is small. If the overlap is smaller, the component absorbs its own emission to a smaller degree.

Specifically, there can be used the compounds represented by the following formula (1):

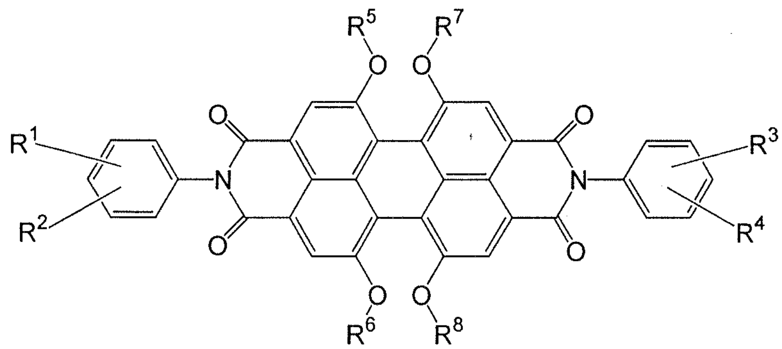

(1)

wherein $R^1$ to $R^4$ are each hydrogen, a linear alkyl group, a branch alkyl group or a cycloalkyl group, and may be substituted; $R^5$ to $R^8$ are a phenyl group, a heteroaromatic group, a linear alkyl group or a branch alkyl group, and may be substituted; and $R^1$ to $R^8$ may be the same or different.

In the formula (1), the linear alkyl group is preferably ones having 1 to 9 carbon atoms such as methyl, ethyl, propyl and butyl, more preferably ones having 6 to 8 carbon atoms.

The branch alkyl group is preferably isopropyl, isobutyl, tert-butyl, 2-ethylhexyl, neopentyl, or cyclohexylmethyl, more preferably isopropyl or neopentyl.

The cycloalkyl group is preferably cyclohexyl or cyclopentyl.

The heteroaromatic group is preferably pyridyl or quinolyl.

The concentration of the component (B) contained in a fluorescence conversion medium is preferably 0.1 to 10 wt%, more preferably 0.2 to 5 wt%. If the concentration is less than 0.1 wt%, the resultant color conversion medium may not convert the color of light sufficiently. If the concentration exceeds 10 wt%, concentration quenching may lower the color conversion efficiency or a highly fine pattern may not be formed.

(C) Second fluorescent dye

The component (C) may be any fluorescent dyes that absorb light in the ultraviolet to blue region (wavelengths of 300 nm to 500 nm) to emit light having a longer wavelength than that of the absorbed light (wavelenghths of 430 nm to 575 nm, for example).

Specifically, perylene fluorescent dyes, coumarin dyes, phthalocyanine dyes, stilbene dyes, cyanine dyes, polyphenylene dyes and rhodamine dyes can be given.

In the invention, as the component (C), fluorescent dyes are preferably used which have a high light conversion efficiency and high durability, and the excitation and fluorescence spectra of which overlap to a small degree, so that the dyes absorb their own emission to a small degree. Specifically, the component (C) is preferably perylene dyes of

the following formula (2).

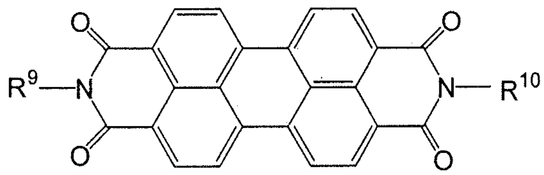

(2)

wherein $R^9$ and $R^{10}$ are each hydrogen, a linear alkyl group, a branch alkyl group or a cycloalkyl group, and may be substituted; and $R^9$ and $R^{10}$ may be the same or different.

In the formula (2), the linear alkyl group is preferably ones having 1 to 9 carbon atoms such as methyl, ethyl, propyl and butyl, more preferably ones having 6 to 8 carbon atoms.

The branch alkyl group is preferably isopropyl, isobutyl, tert-butyl, 2-ethylhexyl, neopentyl, or cyclohexylmethyl, more preferably isopropyl or neopentyl.

The cycloalkyl group is preferably cyclohexyl or cyclopentyl.

The concentration of the component (C) contained in the fluorescence conversion medium is preferably 0.1 to 10 wt%, more preferably 0.2 to 5 wt%. If the concentration is less than 0.1 wt%, the resultant color conversion medium may not convert the color of light sufficiently. If the concentration exceeds 10 wt%, concentration quenching may lower the color conversion efficiency or a highly fine pattern may not be formed.

(D) Third fluorescent dye

The component (D) is a fluorescent dye of which the absorption edge on the long-wavelength side is a longer wavelength than that of the second fluorescent dye (C). Thus the component (D) can absorb light from the component (C) and transmit light of longer wavelength light (energy) to the component (B).
Specifically, the dye can be selected appropriately from perylene fluorescent dyes, coumarin dyes, phthalocyanine dyes, stilbene dyes, cyanine dyes, polyphenylene dyes and rhodamine dyes.

As the component (D), fluorescent dyes are preferably used which have a high light conversion efficiency and high durability, and the excitation spectrum and fluorescence spectra of which overlap to a small degree, so that the dyes absorb their own emission to a small degree. Specifically, the component (D) is preferably perylene dyes of the following formula (3).

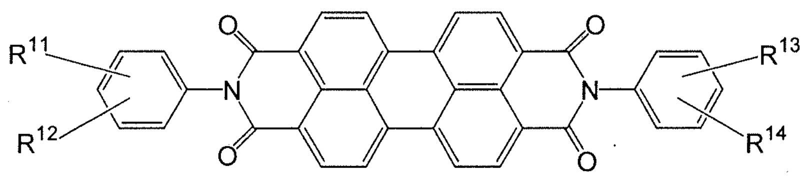

(3)

wherein $R^{11}$ to $R^{14}$ are each hydrogen, a linear alkyl group, a branch alkyl group or a cycloalkane, and may be substituted; and $R^{11}$ to $R^{14}$ may be the same or different.

In the formula (3), the linear alkyl group is preferably ones having 1 to 9 carbon atoms such as methyl, ethyl, propyl and butyl, more preferably ones having 6 to 8 carbon atoms.

The branch alkyl group is preferably isopropyl, isobutyl, tert-butyl, 2-ethylhexyl, neopentyl, or cyclohexylmethyl, more preferably isopropyl or neopentyl.

The cycloalkyl group is preferably cyclohexyl or cyclopentyl.

The concentration of the component (D) contained in the fluorescence conversion medium is preferably 0.1 to 10 wt%, more preferably 0.2 to 5 wt%. If the concentration is less than 0.1 wt%, the resultant color conversion medium may not convert the color of light sufficiently. If the concentration exceeds 10 wt%, concentration quenching may lower the color conversion efficiency or a highly fine pattern may not be formed.

In the specification, the "absorption edge" means the amount of absorbed light that contributes to fluorescence emission, that is, the wavelength that is longer than the wavelength at which absorption is maximum in a region of 300

nm to 600 nm in an excitation spectrum, and at which the excitation strength is 1/20 the maximum value.

The compounds of the above formulas (1) to (3) can be synthesized by known methods for synthesizing perylene dyes. They can also be selected from commercially available perylene dyes.

In the invention, it is preferred that the component (C) and/or component (D) be a perylene fluorescent dye, thereby allowing the red fluorescence conversion medium to have a high durability.

In addition to the above components (A) to (D), if necessary, additives such as a photopolymerization initiator, radiosensitizing agent, curing accelerator, thermal polymerization inhibitor, plasticizer, filler, solvent, antifoamer and leveling agent can be incorporated.

In the red fluorescence conversion medium of the invention, the relationship between a maximum value of the optical density OD1 in a wavelength region of 600 nm to 700 nm, and a maximum value of the optical density OD2 in a wavelength region of 400 nm to 500 nm preferably statisfies OD2/OD1 > 1.5.

The optical density (OD) indicates a value showing the degree in which a red fluorescence conversion medium absorbs light of a certain wavelength. The optical density at a wavelength λ, $OD_\lambda$ is represented by the following formula wherein $T_\lambda$ (%) is a light transmittance.

$$OD_\lambda = \log\left(\frac{100}{T_\lambda}\right)$$

The optical density is not standardized with a distance of a fluorescence conversion medium through which light passes, that is, the thickness thereof. The ratio of a maximum (OD2) in an exciting-light region of 400 to 500 nm to a maximum (OD1) in an emitted light region of 600 to 700 nm can be an index of the light-absorbing efficiency and color purity of a fluorescence conversion medium.

The red fluorescence conversion medium of the invention can satisfy OD2/OD1 > 1.5 since it is excellent in color conversion efficiency and color purity. OD2/OD1 is particularly preferably 3 or more.

The red fluorescence conversion medium of the invention may further comprise a light-scattering material. As the light-scattering material, organic and/or inorganic particles can be given.

The organic particles include vinyl polymers such as polymethylmethacrylate and polystyrene, melamine resins, polyamide resins and epoxy resins.

The inorganic particles include particles of inorganic oxides, inorganic nitrides and inorganic oxynitrides. Specifically, SiOx, SiNx, SiOxNy, AlOx, TiOx, TaOx, ZnOx, ZrOx, CeOx and ZrSiOx wherein x is 0.1 to 2 and y is 0.5 to 1.3 can be given. Of these, TiOx, ZnOx, ZrOx and CeOx are preferable. A coating layer which suppresses the quenching of fluorescent dyes can be formed on the surfaces of particles. The coating layer which suppresses the quenching of fluorescent dyes includes layers which prevent destruction of fluorescent dyes and light-transmitting media by particles having a photocatalytic action and layers which insulate semiconductive particles. Materials for forming such a coating layer include alumina, zirconia, silica, silicate zirconia, silicate alumina and glass such as borosilicate glass.

The particles may be hollow. When using the hollow particles, the refractive index of air (hollow parts) for a fluorescence conversion medium is large (the refrective index of air is 1.0, while that of a fluorescence conversion medium is about 1.5 to 1. 6) and light greatly scatters. The oxygen in the hollow body may preferably suppress the degradation of a fluorescent dye.

Of these particles, particles with a high refractive index or particles with a low refractive index preferably have a refractive index of 2.0 to 2.8 or 1.0 to 1.2, respectively. Such particles can enlongate the optical path length of light from an excitation light source in a fluorescence conversion medium, so that the fluorescence conversion medium can efficiently absorb light from the source. In addition, the particles scatter converted light to enhance an outcoupling efficiency. As a result, the conversion efficiency of the fluorescence conversion medium can be improved. Such particles include $TiO_2$ particles (refractive index: 2.7), ZnO (refractive index: 2.0), $CeO_2$ (refractive index: 2.4), $ZrO_2$ (refractive index: 2.2), hollow silica and hollow glass.

The primary average diameter of the particles is preferably, not limited to, 1 nm or more and less than 100 nm, particularly preferably 5 nm or more and less than 80 nm. If it is 100 nm or more, the particles may not be uniformly dispersed in a fluorescence conversion medium whereby emission may be nonuniform or a fine patterning by photolithography may be difficult. If it is less than 1 nm, sufficient light scattering may not occur. Although particles may aggregate to a diameter of 100 nm or more, there are no problems so far as the particles have a primary average diameter of 1 nm or more and less than 100 nm.

The amount of particles added in a fluorescence conversion medium is not limited so far as the haze value is in the above mentioned range. In general, the amount is preferably more than 5 wt% and less than 70 wt%, particularly

preferably more than 10 wt% and less than 50 wt%. If the amount is 5 wt% or less, sufficient light scattering may not occur. If the amount is 70 wt% or more, the fluorescence conversion medium may be mechanically brittle.
The above organic or inorganic particles may be used either singly or in combination of two or more.

The red fluorescence conversion medium of the invention can provide red with a high color purity. In order to further enhance a purity, a color filter for adjusting color can be stacked on the medium.
For example, an exciting-light source, fluorescence conversion medium and color filter can be stacked in this order. In fabricating, the exciting-light source may be firstly formed, or the color filter may be firstly formed. Alternatively two parts may be separately formed to be adhered to each other.

The red fluorescence conversion medium of the invention can be made by common methods known in the art. For example, the above components (A) to (C), if necessary, and the component (D) and additives such as curing agents are mixed in a suitable solvent to obtain a solution. The solution is applied on the surface of a substrate and dried, thereby forming the medium.
The red fluorescence conversion medium and color filter may be patterned according to applications. For patterning, methods such as photolithography, ink jet, screen printing, anastatic printing and electrophotography can be used.

The red fluorescence conversion medium of the invention may be arranged on a transparent substrate, thereby forming a color conversion substrate. A green fluorescence conversion medium may additionally be arranged in this color conversion substrate.
Specifically, the red fluorescence conversion medium of the invention, or the red and green fluorescence conversion media is patterned and arranged in a plane on a transparent substrate by the above-mentioned methods.
If necessary, there may be arranged the above-mentioned color filter for color adj ustment, a black matrix for contrast improvement and an overcoating layer for flattenization and protection on a fluorescent medium.
The green fluorescence conversion medium preferably uses the fluorescent dye of component (C) and the light-transmitting medium of component (A) and, if necessary, contains the above-mentioned light-scattering materials.

The transparent substrate is a substrate for supporting a color conversion substrate or luminescent device, and is preferably a flat and smooth substrate having a transmittance of 50% or more to light rays within visible ranges of 400 nm to 700 nm. Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

The red fluorescence conversion medium of the invention constitutes a light-emitting apparatus together with an exciting-light source.
As the exciting-light source, there may be used a light source emitting ultraviolet to blue components, preferably a light source converting electrical energy to electromagnetic rays such as light, and exciting-light such as natural light (e.g. sunlight) and radial rays.
The light source converting electrical energy to light includes an organic EL device, inorganic EL device, inorganic LED, fluorescent lamp, cold cathode lamp, mercury lamp, arc-lamp, excimer discharge lamp and filament emission lamp.
Preferable natural light is sunlight. If only blue components are taken out with a prism or dichronic mirror and used for conversion, energy conversion efficiency is preferably enhanced.

An exciting-light source is preferable for the light-emitting apparatus of the invention which has one or more emission peaks in a wavelength region of 400 nm to 500 nm.
Specifically a blue organic EL device, blue EL device, blue LED, blue cold cathode lamp, blue fluorescent lamp, blue surface discharge panel and the like can be preferably used.

The light-emitting apparatus of the invention may be a white-light-emitting apparatus wherein fluorescence from a red fluorescence conversion medium and light from an exciting-light source are mixed to obtain white light. FIG. 2 is a schematic sectional view showing an embodiment of the white-light-emitting apparatus according to the invention. The light-emitting apparatus comprises a color conversion substrate 10 and an exciting-light source 20. The color conversion substrate 10 is formed by patterning a red fluorescence conversion medium 12 on the lower surface of a transparent substrate 11. The exciting-light source 20 is formed on the upper surface of the transparent substrate 11. The exciting-light source 20 emits light in blue to blue green which may contain a red component. In this drawing, an arrow shows light, B shows blue light, G shows green light and R shows red light.
In the apparatus, part of light emitted from the source 20 enters into the red fluorescence conversion medium 12 to generate red fluorescence. Light that passes through the region where the red fluorescence conversion medium 12 is not formed remains unchanged as light emitted by the source 20. The blue to blue green light is combined with the red light to produce white emission (W in FIG. 2).

Unlike the present embodiment, the exciting-light source and red fluorescence conversion medium may be arranged in the same plane. In this case, part of light from the source excites the red fluorescence conversion medium, while part of the light passes without exciting, which part can be used as a part of white light as it is. The fluorecence emitted from the red fluorescence conversion medium has a high red converting efficiency and is strong, since the

medium sufficiently absorbs light from the source. Thus strong white light can be efficiently obtained.

In the invention, white light with various color temperatures and color rendering indexes can be easily designed by adjusting the light intensity of exciting-light source and fluorescence intensity of red fluorescence conversion medium. For example, the area of the red fluorescence conversion medium that receives exciting light and the area through which light passes without exciting are adjusted, or the emission spectrum of light emitted from the exciting-light source is adjusted.

Further since the red fluorescence conversion medium of the invention has a high durability, a white-light-emitting apparatus with a small change in color and good durability can be obtained.

For example, a white-light-emitting apparatus can be obtained by combining the above color conversion substrate with an organic EL device or inorganic EL device.

In order to enhance the uniformity of white light, a light-scattering means may be arranged on the side of fluorescence medium from which light is outcoupled. The means includes a light transparent medium containing a light-scattering material and scattering plate with a rough surface from which light is outcoupled.

A full-color display can be obtained by enabling driving individual subpixels independently (e.g., TFT active or passive driving).

Examples

The invention will be described in more detail by examples below.

The properties of fluorescent dyes and red fluorescence conversion media were measured and evaluated as follows:

(1) Absorption edge of fluorescent dye

A fluorescent dye was dissolved in 2-acetoxy-1-ethoxypropane in a suitable concentration, e.g., 0.01 wt%. The solution was measured for an excitation/fluorescence spectrum with a fluorospectrophotometer (manufactured by Shimadzu corporation, RF-5000). The wavelength that is longer than the wavelength at which a maximum was observed in a 300 nm to 600 nm region of the spectrum, and at which the excitation strength is 1/20 the maximum value was taken as an absorption edge.

(2) Relative fluorescence intensity

A fluorescence conversion medium and a color filter for color adjustment were sequentially arranged on a blue organic EL device with a peak wavelength of 470 nm. The spectrum of light transmitted through the fluorescence conversion medium was measured with a spectroluminance meter (MINOLTA Co., Ltd., CS1000) in a 2 degree viewing field. The spectrum was compared with the emission spectrum of the blue organic EL device, and the relative fluorescence intensity of the fluorescence conversion medium was calculated using the following calculation formula.

The relative fluorescence intensity is referenced to the peak of red emission intensity from a fluorescence conversion medium formed in Comparative Example 2 described later that was taken as 1.

Relative fluorescence intensity = (red emission intensity of fluorescence conversion medium to be compared) /(red emission intensity of fluorescence conversion medium formed in Comparative Example 2)

A maximum intensity of emission spectrum in a wavelength range of 575 nm to 700 nm was taken as the red emission intensity.

Fabrication of the blue organic EL device used was described in Preperation Example 1 mentioned later.

(3) Durability test of red fluorescence conversion medium

Exciting light was irradiated to a fluorescence conversion medium using a 400 nit blue LED light source in a nitrogen atomosphere for 1000 hours at room temperature. Changes in luminance and chromaticity CIE (x, y) during the period were evaluated.

Example 1

(1) Preparation of color converting material composition solution

As a light-transmitting medium of the component (A), a mixture of 2.3 g of methylmethacrylate-methacrylic acid copolymer (A.C.C. Inc., average molecular weight 15,000), 1.5 g of dipentaerithritol hexacrylate (TOAGOSEI CO., LTD. , ARONIX M-400) and 0.4 g of a cresol novolac-type epoxy resin (Asahi Kasei Corporation, ECN 1299) was used.

As the component (B), 11.5 mg of a perylene fluorescent dye of the following formula (4) was used.

As the component (C), 23 mg of a perylene fluorescent dye (absorption edge: 495 nm) of the following formula (5) was used.
As the component (D), 23 mg of a perylene fluorescent dye (absorption edge: 544 nm) of the following formula (6) was used.
The above components (A) to (D) were dissolved in 5.5 g of 2-acetoxy-1-ethoxypropane (Wako Pure Chemical Industries, Ltd.) to obtain a color converting material composition.
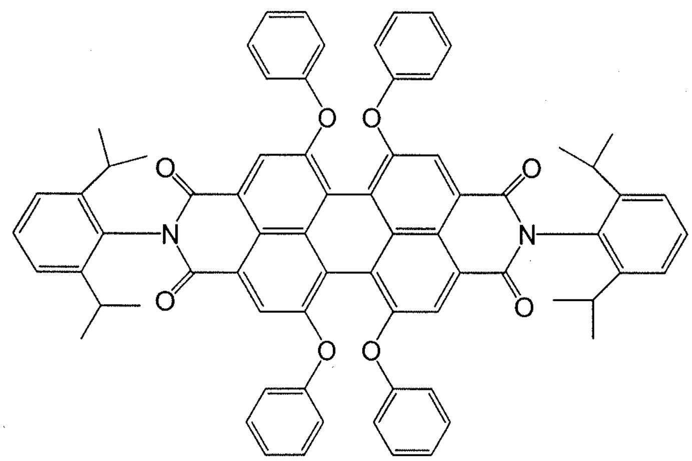

(4)

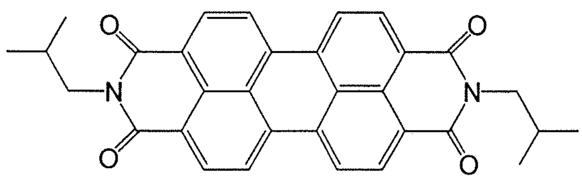

(5)

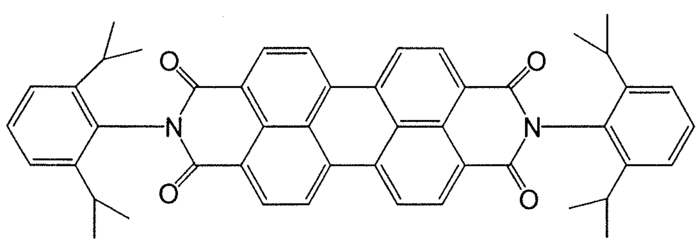

(6)

(2) Production of red fluorescence conversion medium

Next, by using the color converting material composition prepared in (1), a film was formed on a glass substrate measuring 2.5 cm × 5 cm by spin coating at a spin-coater rotating speed of 500 rpm for a rotating time of 10 seconds. The film was subjected to a drying treatment at 80°C for 15 minutes, irradiarion of ultraviolet rays of 300 mJ/$cm^2$ and then heat treatment at 180°C for 30 minutes, thereby obtaining a red fluorescence conversion medium with a thickness of about 10 μm.

(3) Evaluation of red fluorescence conversion medium

FIG. 3 shows optical density (OD) spectra of the red fluorescence conversion media formed in Example 1 and Comparative Example 2 described later.
The spectra confirmed that OD2/OD1, which indicates a ratio of light absorption in an exciting-light region to light absorption in a light emission region, showed high absorption of 4. 9 (OD2/OD1 = 0.453/0.093).

The relative fluorescence intensity of the fluorescence conversion medium was 1.7, which showed a very high efficiency.

The results of the durability test are shown in FIGs. 4 to 6. FIG. 4 is a view showing the relationship between an irradiation time of exciting light and amount of changes in luminance. FIG. 5 is a view showing the relationship between an irradiation time of exciting light and amount of changes in chromaticity (CIEx). FIG. 6 is a view showing the relationship between an irradiation time of exciting light and amount of changes in chromaticity (CIEy).

The results revealed that the luminance remained 98% or more of the initial value and the changes in chromaticity CIEx and CIEy were both only 0.005 or less even after 1000 hours elapsed, that is, the degree of degradation was very small.

The red fluorescence conversion medium with a color filter formed in Preperation Example 2 described later thereon was measured for chromaticity using a light source similar to that for fluorescence intensity measurement. It was found that bright red with CIE (x, y) = (0.631, 0.363) was obtained.

Table 1 shows evaluation results of fluorescent dyes used and the red fluorescence conversion media formed in Example 1, and Examples 2 to 4 and Comparative Examples 1 to 3 described below.

Table 1

| | Fluorescent dye used | | | Emission color | Durability test | | OD2/OD1 | Relative fluorescence intensity |
|---|---|---|---|---|---|---|---|---|
| | Component (B) | Component (C) | Component (D) | | Luminance change | Chromaticity change | | |
| Example 1 | Formula (4) | Formula (5) | Formula (6) | Red | ◎ | ◎ | 4.9 | 1.7 |
| Example 2 | Formula (4) | Formula (5) | - | Red | ◎ | ◎ | 3.6 | 1.3 |
| Example 3 | Formula (4) | Formula (5) | Rhodamine 6G | Red | ○ | ◎ | 4.3 | 1.6 |
| Example 4 | Formula (4) | Coumarin 6 | Formula (6) | Red | ○ | ◎ | 4.1 | 1.6 |
| Comparative Example 1 | Rhodamine B | Coumarin 6 | Rhodamine 6G | Red | × | × | 7.5 | 1.7 |
| Comparative Example 2 | Formula (4) | - | - | Red | - | - | 1.1 | 1 |
| Comparative Example 3 | - | Formula (5) | - | Orange | - | - | 9.1 | 0.65 |

The emission color is the color of light emitted from a red fluorescence conversion medium formed. Luminance change: ◎; 5% or less, ○; more than 5% and 10% or less, ×; more than 10% Chromaticity change: ◎; 0.01 or less, ×; more than 0.01

Example 2

A red fluorescence conversion medium was formed and evaluated in the same manner as in Example 1 except that the third fluorescent dye of the component (D) was not added.

FIG. 7 shows optical density (OD) spectra of the red fluorescence conversion media formed in Example 2 and Comparative Example 2 described later.
The spectra confirmed that OD2/OD1 showed high absorption of 3.6 (OD2/OD1 = 0.356/0.098).
The relative fluorescence intensity of the fluorescence conversion medium was 1.3, which showed a very high efficiency.

As a result of durability test, it was found that the luminance remained 95% or more of the initial value and the changes in chromaticity CIEx and CIEy were both only 0.005 or less even after 1000 hours elapsed. That is, the degree of degradation was very small.

Example 3

A red fluorescence conversion medium was formed and evaluated in the same manner as in Example 1 except that 23 mg of rhodamine 6G (Aldrich, absorption edge: 535 nm) was used as the third fluorescent dye of the component (D).

The optical density (OD) spectrum of the red fluorescence conversion medium confirmed that OD2/OD1 showed high absorption of 4.3.
The relative fluorescence intensity of the fluorescence conversion medium was 1.6, which showed a very high efficiency.
As a result of durability test, it was found that the luminance remained 90% or more and the changes in chromaticity CIEx and CIEy were both only 0.01 or less after 1000 hours elapsed. That is, the degree of degradation was very small.

Example 4

A red fluorescence conversion medium was formed and evaluated in the same manner as in Example 1 except that 23 mg of coumarin 6 (Aldrich, absorption edge: 518 nm) was used as the second fluorescent dye of the component (C).

The optical density (OD) spectrum of the red fluorescence conversion medium confirmed that OD2/OD1 showed high absorption of 4.1.
The relative fluorescence intensity of the fluorescence conversion medium was 1.6, which showed a very high efficiency.
As a result of durability test, it was found that the luminance remained 90% or more and the changes in chromaticity CIEx and CIEy were both only 0.01 or less even after 1000 hours elapsed. That is, the degree of degradation was very small.

Comparative Example 1

A red fluorescence conversion medium was formed and evaluated in the same manner as in Example 1 except that the following compounds were used as the components (B) to (D);
Components (B): rhodamine B (Aldrich): 23 mg
Components (C): coumarin 6 (Aldrich): 23 mg
Components (D): rhodamine 6G (Aldrich): 23 mg

FIG. 8 shows the optical density (OD) spectrum of red fluorescence conversion medium of Comperative Example 1.
The spectrum confirmed that OD2/OD1 showed high absorption of 7.5.
The relative fluorescence intensity of the fluorescence conversion medium was 1.7, which showed a very high efficiency.

The results of the durability test are shown in FIGs. 9 to 11. FIG. 9 is a view showing the relationship between an irradiation time of exciting light and amount of changes in luminance. FIG. 10 is a view showing the relationship between an irradiation time of exciting light and amount of changes in chromaticity (CIEx). FIG. 11 is a view showing the relationship between an irradiation time of exciting light and amount of changes in chromaticity (CIEy).
The results revealed that the luminance greatly deteriorated to 85% or less of the initial value, and for chromaticity, CIEx changed by 0. 01 or more and CIEy changed by 0. 008 or more even after 1000 hours elapsed. That is, the degree of degradation was large.

Comparative Example 2

A red fluorescence conversion medium was formed and evaluated in the same manner as in Example 1 except that the components (C) and (D) were not added.

The optical density (OD) spectrum of the red fluorescence conversion medium confirmed that OD2/OD1 was as low as 1.1.

The relative fluorescence intensity of the fluorescence conversion medium was 1.0 since a relative fluorescence intensity was calculated using the present Example as a standard.

Comparative Example 3

A red fluorescence conversion medium was formed and evaluated in the same manner as in Example 1 except that the components (B) and (D) were not added.

The optical density (OD) spectrum of the red fluorescence conversion medium confirmed that OD2/OD1, an index of light absorption and light transmission, was as high as 9.1. However, it was found that the light color was orange and the light components contained a small amount of red components, that is, the performance as a red fluorescence conversion medium was inferior.

The relative fluorescence intensity of the fluorescence conversion medium was as low as 0.65.

Example 5

A transparent resin in a bombshell-type upper part of a blue LED (Toyoda Gosei Co.,Ltd, E1L35-3B) was sufficiently removed. The blue LED was used at an exciting-light source. The color converting material composition solution prepared in Example 1 (1) was thinly applied on the removed part using a needle tip.

The resultant blue LED was dried in an oven at 80˚C for 15 minutes, irradiated with ultraviolet rays of 300 $mJ/cm^2$ and subjected to a heat treatment at 180˚C for 30 minutes to produce a fluorescence conversion medium with a thickness of about 15 μm.

A red color resist (Fuj i-Hunt Electronics Technology Co. Ltd. , CR-2000) was diluted by about twice with 2-acetoxy-1-ethoxypropane (Wako Pure Chemical Industries, Ltd.). The diluted resist was put on the needle tip, thinly applied on the fluorescence conversion medium, dried in the oven at 80˚C and cured at 200˚C to form a color filter with a thickness of about 2 μm.

A direct current voltage of 3.2 V was applied to a LED with the red fluorescence conversion medium. As a result, bright red light with an emission spectrum shown in FIG. 12 was obtained. The emission spectrum of a blue LED is also shown in FIG. 12. The CIE chromaticity (x, y) of the emitted light was (0.626, 0.364).

For comparison, a LED of which the transparent resin was removed but on which a color conversion medium was not applied was caused to emit light. When applying 3.2 V, the LED emitted 500 nit blue light. Next, a fluorescence conversion medium was applied on the LED. The resultant LED emitted 170 nit red light. That is, the luminance converting efficiency was as high as 34%.

Even after a continuous lighting test of 1000 hours, almost no changes in color and luminance were observed.

As mentioned above, it was found that, by using the red fluorescence conversion medium obtained by the invention and a light source having light components in a blue region of 400 to 500 nm, efficiency and durability can be improved regardless of the light source.

Example 6 (red fluorescence conversion medium containing light-scattering material)

A solution of color converting material composition was formed and a red fluorescence conversion medium was obtained in the same manner as in Example 1 except that 0.4 g of titanium oxide particles coated with alumina (Tayca Corporation, MT500HD, primary average particle diameter 30 nm, refractive index 2.7) as a light-scattering material and 0.5 g of 2-acetoxy-1-ethoxypropane were added.

The relative fluorescence intensity of the red fluorescence conversion medium was 2.0, which indicated that this conversion medium was further more efficient than that prepared in Example 1.

Example 7 (White-light-emitting apparutus using red fluorescence medium)

A blue-green-light-emitting organic EL device was fabricated in the same manner for fabricating a blue-light-emitting organic EL device in Preparation Example 1 described later except that, for luminescent materials, DPVBi was used as a host, 1,4-bis[4-(N,N-diphenylaminostyrylbenzene)] (DPAVB) was used as a dopant, and DPVBi and DPAVB were co-deposited at depositing speeds of 0.1 to 0.3 nm/second and 0.03 to 0.05 nm/second, respectively to form a 50 nm thick emitting layer. FIG. 13 shows the emission spectrum of the device.

A red fluorescence medium pattern (color conversion substrate) was formed in the same manner as in Example 1 except that a film was formed from a color converting material composition on a glass substrate, irradiated with ultraviolet rays through a photomask having an open ratio of 70% (stripe pattern of 30 μm lines and 70 μm gaps) and developed with a 2.4% TMAH (tetramethylammonium hydroxide) solution to produce the red fluorescence medium pattern with an open ratio of 30% (stripe pattern of 70 μm lines and 30 μm gaps) on the glass substrate.

The color conversion substrate was adhered to the surface of the glass substrate, which surface was opposed to the surface where the blue-green-light-emitting organic EL device was formed, such that the red conversion medium pattern faced the organic EL device, thereby fabricating a white-light-emitting apparatus.
The blue-green-light-emitting organic EL device was caused to emit light and the light was observed from the color conversion substrate side. The light was white of which the chromaticity CIE (x, y) was (0.299, 0.354), the color temperature was about 7000 K, and Ra (color rendering index) was 75%.

Preparation Example 1

Fabrication of blue-light-emitting organic EL device

A glass substrate measuring 25 mm × 75 mm x 1.1 mm, on which an ITO electrode was formed in a thickness of 100 nm, was used as a transparent supporting substrate.
The transparent supporting substrate was subjected to ultrasonic cleaning with isopropyl alcohol for 5 minutes, cleaning with pure water for 5 minutes, and then ultrasonic cleaning with isopropyl alcohol for 5 minute again.
Next, the resultant transparent supporting substrate was fixed in a substrate holder of a vacuum deposition apparatus. A molybdenum boat for resistance heating was charged with 200 mg of 4,4'-bis(N-phenyl-N-(3-methylphenyl)amino) biphenyl (TPD). Other molybdenum boats for resistance heating were charged with 200 mg of tris(8-quinolinol)aluminum (Alq) and 4,4'-bis(2,2-diphenylvinyl)biphenyl (DPVBi). A vacuum chamber was then evacuated to $1 \times 10^{-4}$ Pa. By heating the boat with TPD therein to 215 to 220°C, TPD was deposited onto the substrate at a deposition speed of 0.1 to 0.3 nm/second to form a 60 nm thick hole-injecting layer. At this time, the substrate temperature was room temperature.
Without removing the hole-injecting layer from the vacuum chamber, DPVBi was deposited thereon at a boat temperature of 250°C and a depositing speed of 0.1 to 0.2 nm/second to form a 40 nm thick emitting layer.
Next, Alq was deposited at a boat temperature of 250°C and a depositing speed of 0.1 to 0.3 nm/second to form a 20 nm thick electron-transpoting layer.
The resultant product was removed from the vacuum chamber. A stainless steal mask was arranged on the electron-transporting layer. The product with the mask was fixed in the substrate holder again. A tungsten basket was charged with 0.5 g of Ag wire. A molybdenum boat was charged with 1 g of Mg ribbon. After the vacuum chamber was evacuated to $1 \times 10^{-4}$ Pa, Ag (depositing speed: 0.1 nm/second) and Mg (depositing speed: 0.8 nm/second) were co-deposited to form a cathode electrode film, thereby fabricating a blue-light-emitting organic EL device.
FIG. 14 shows the emission spectrum of the organic EL device.

Preparation Example 2

(III) Preparation of color filter for color adjustment

As a color filter for adjusting chromaticity, a red color resist (Fuji-Hunt Electronics Technology Co.Ltd., CR-2000) was spin-coated on a glass substrate, dried in an oven at 80°C, and cured in an oven at 200°C.
Measurement with a surface roughness meter showed that the color filter had a thickness of 2.3 μm. FIG. 15 shows the transmission spectrum of the color filter.

INDUSTRIAL APPLICABILITY

The red fluorescence conversion medium of the invention can be used in public and industrial displays, specifically displays for mobile phones, PDAs, car navigators, monitors and TVs, lightings, and the like.

**Claims**

1. A red fluorescence conversion medium comprising;
a light-transmitting medium,
a first perylene fluorescent dye that emits red fluorescence, and
a second fluorescent dye that absorbs light in a ultraviolet to blue region to emit fluorescence,
wherein the first perylene fluorescent dye absorbs light containing the fluorescence emitted by the second fluorescent dye to emit fluorescence.

2. The red fluorescence conversion medium according to claim 1, further comrising a third fluorescent dye of which the absorption edge of light is a longer wavelength than the absorption edge of light of the second fluorescent dye,

wherein the second fluorescent dye and/or the third fluorescent dye are/is a perylene fluorescent dye.

**3.** The red fluorescence conversion medium according to claim 1 or 2, wherein a relationship between a maxium value of an optical density OD1 in a wavelength region of 600 nm to 700 nm, and a maxium value of an optical density OD2 in a wavelength region of 400 nm to 500 nm is OD2/OD1 > 1.5.

**4.** The red fluorescence conversion medium according to any one of claims 1 to 3, further comprising a light-scatteirng material.

**5.** A color conversion substrate comprising the red conversion fluorescence medium according to any one of claims 1 to 4 on a transparent substrate.

**6.** The color conversion substrate according to claim 5, further comprising a green fluorescence medium.

**7.** A light-emitting apparatus comprising the red fluorescence conversion medium according to any one of claims 1 to 4 and an exciting-light source,
wherein light emitted from the exciting-light source has one or more emission peaks in a wavelength region of 400 nm to 500 nm.

**8.** The light-emitting apparatus according to claim 7, wherein fluorescence emitted from the red fluorescence conversion medium and light emitted from the exciting-light source are mixed to emit white light.

**9.** The light-emitting apparatus according to claim 7 or 8, wherein the exciting-light source is a light source converting electric energy to light.

**10.** The light-emitting apparatus according to claim 7 or 8, wherein the exciting-light source is natural light.

**11.** A light-emitting apparatus comprising the exciting-light source and the color conversion substrate according to claim 5 or 6.

FIG.1

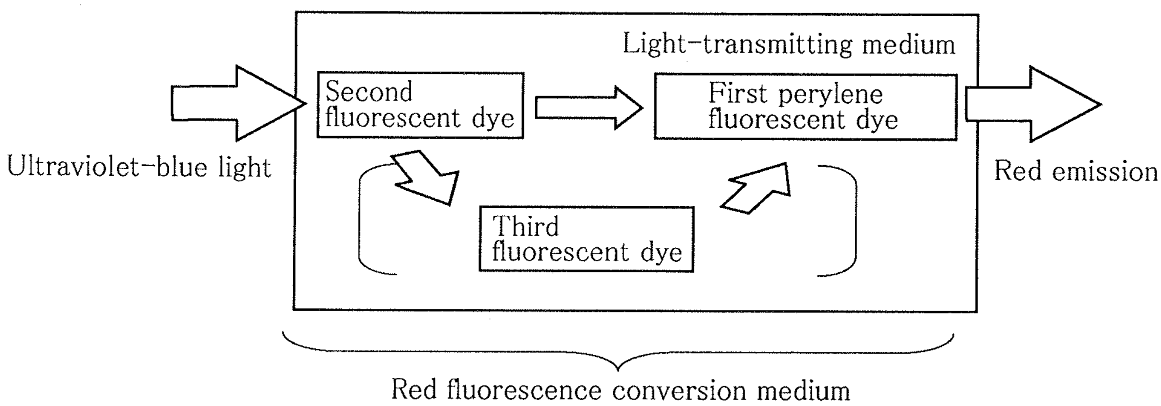
Light-transmitting medium
Second fluorescent dye
First perylene fluorescent dye
Ultraviolet-blue light
Red emission
Third fluorescent dye
Red fluorescence conversion medium

FIG.2

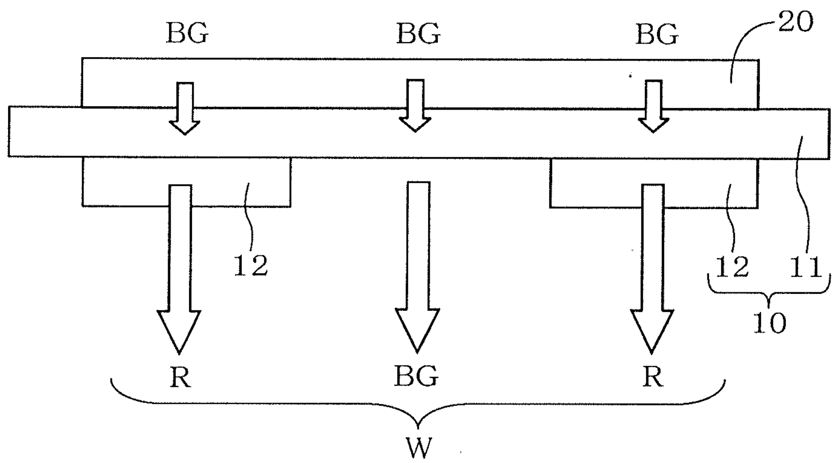
BG
BG
BG
20
12
12
11
10
R
BG
R
W

FIG.3

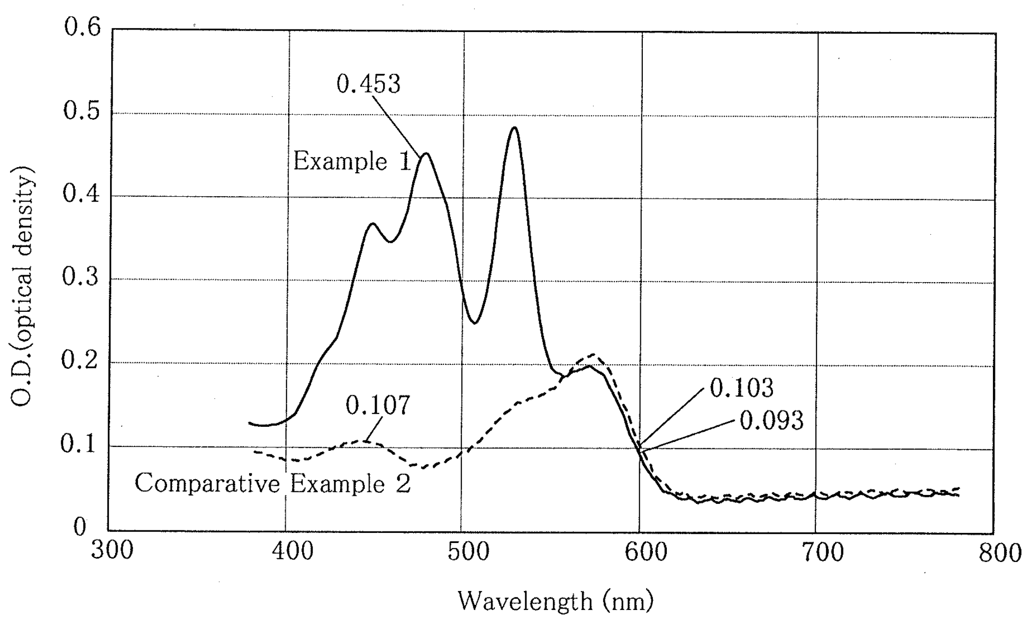


FIG.4

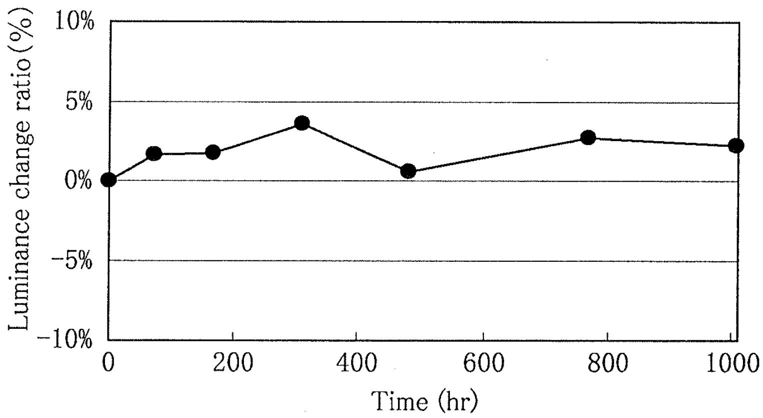


FIG.5

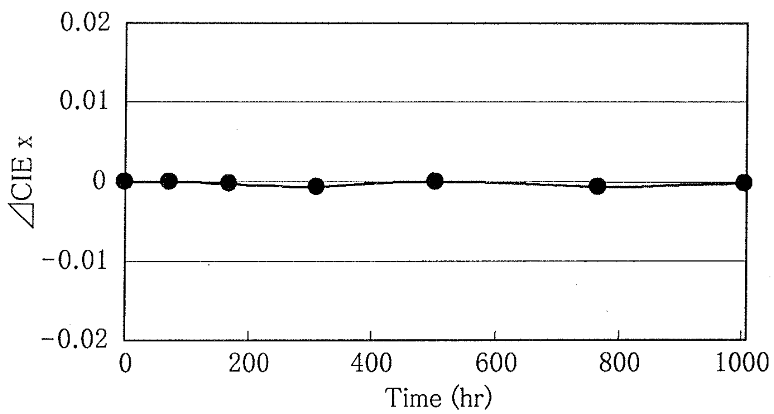

FIG.6

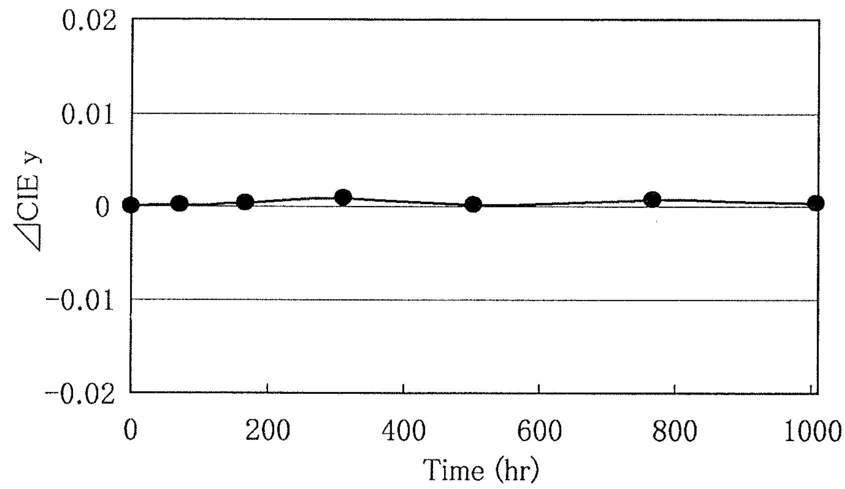
0.02
0.01
0
-0.01
-0.02
⊿CIE y
0
200
400
600
800
1000
Time (hr)

FIG.7

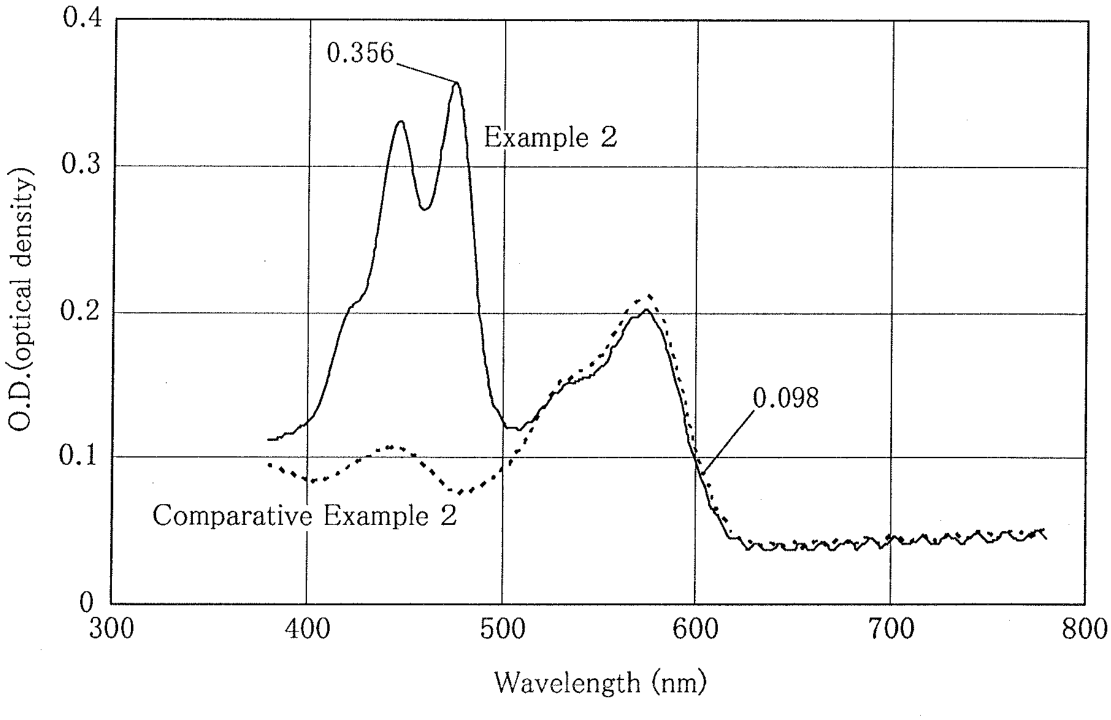
0.4
0.3
0.2
0.1
0
O.D.(optical density)
0.356
Example 2
0.098
Comparative Example 2
300
400
500
600
700
800
Wavelength (nm)

FIG.8

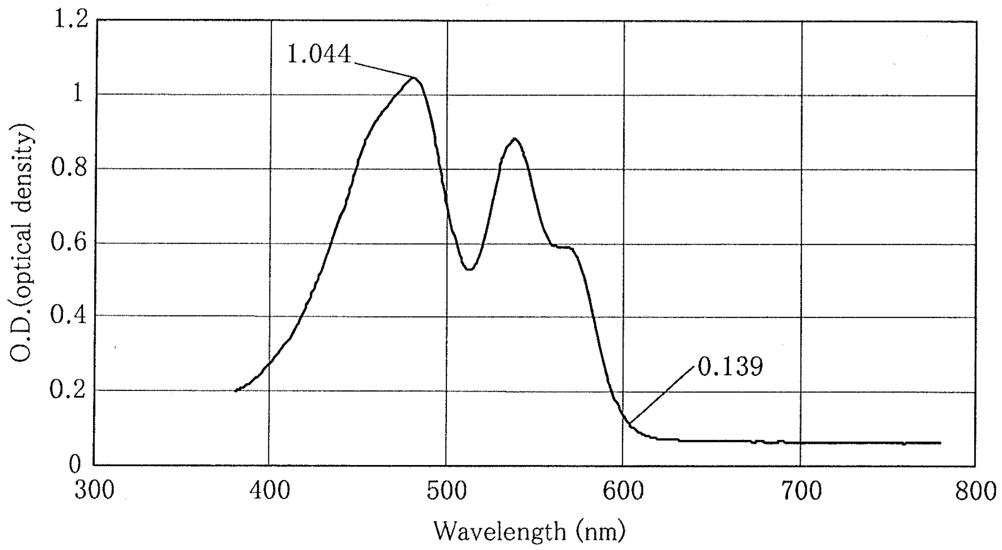


FIG.9

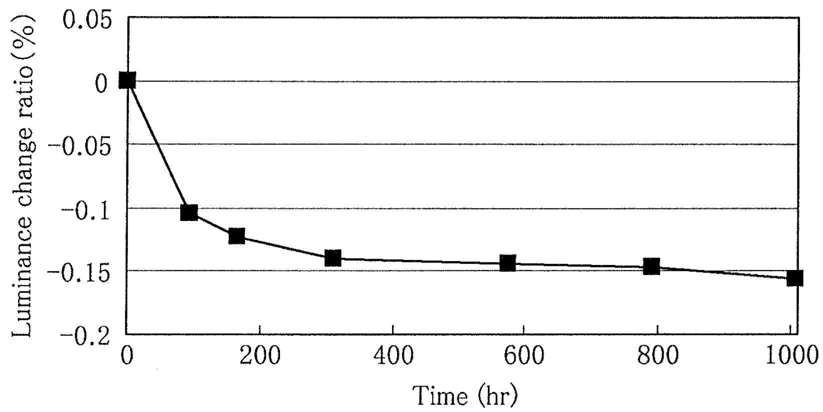


FIG.10

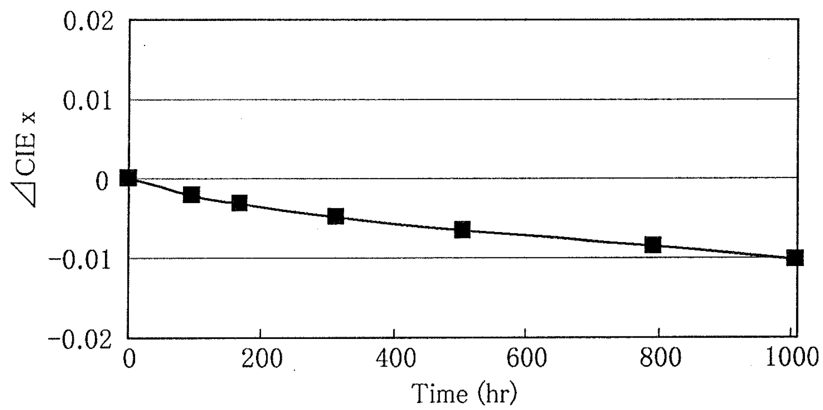

FIG.11

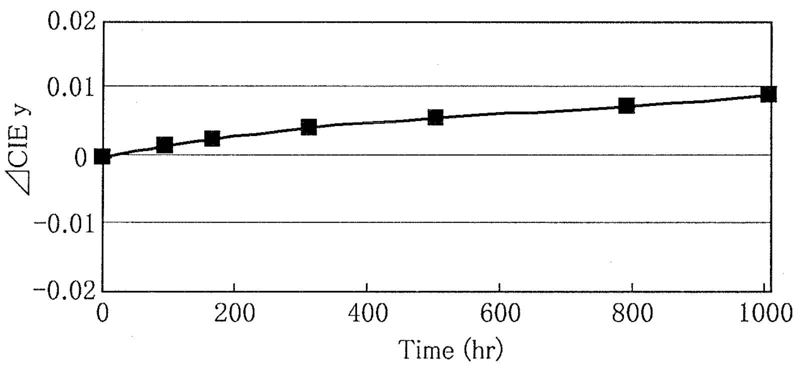


FIG.12

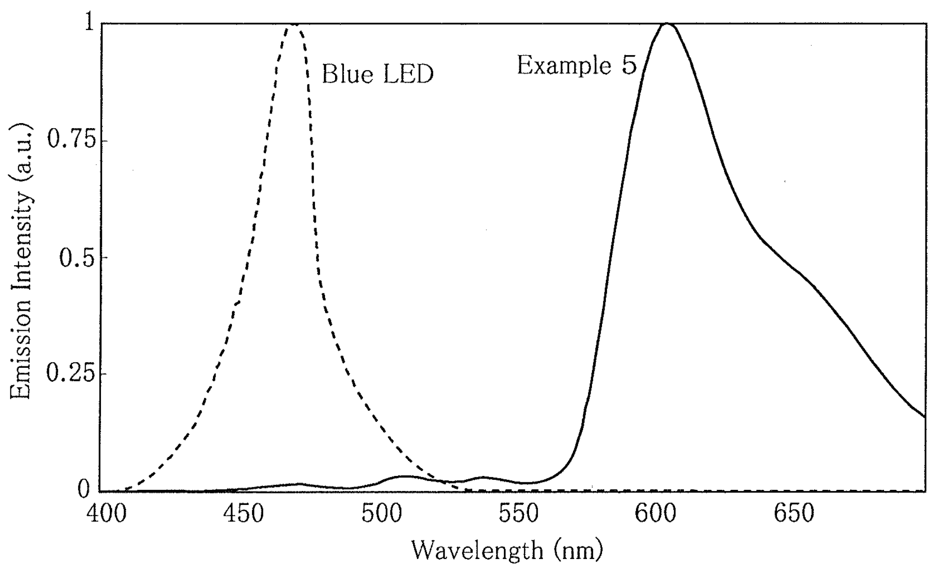


FIG.13

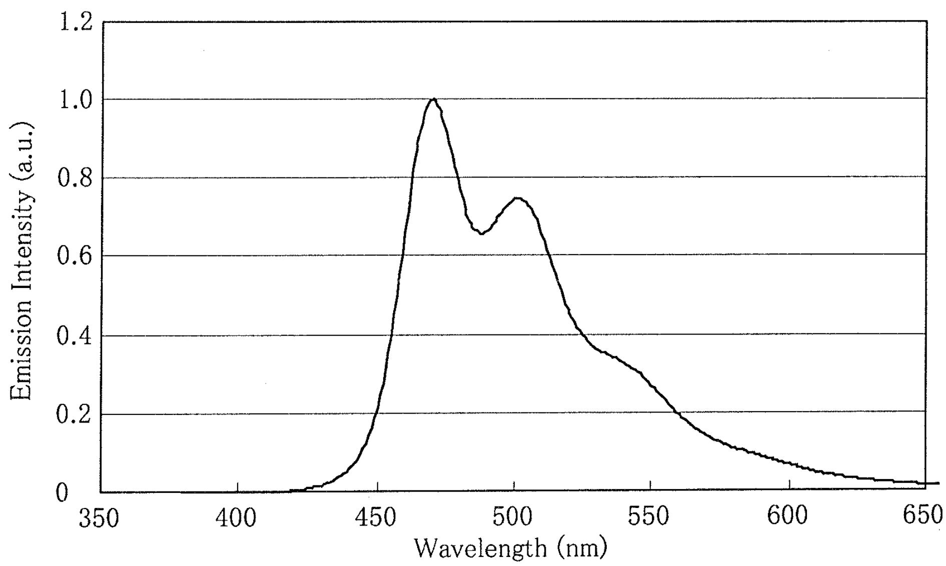

FIG.14

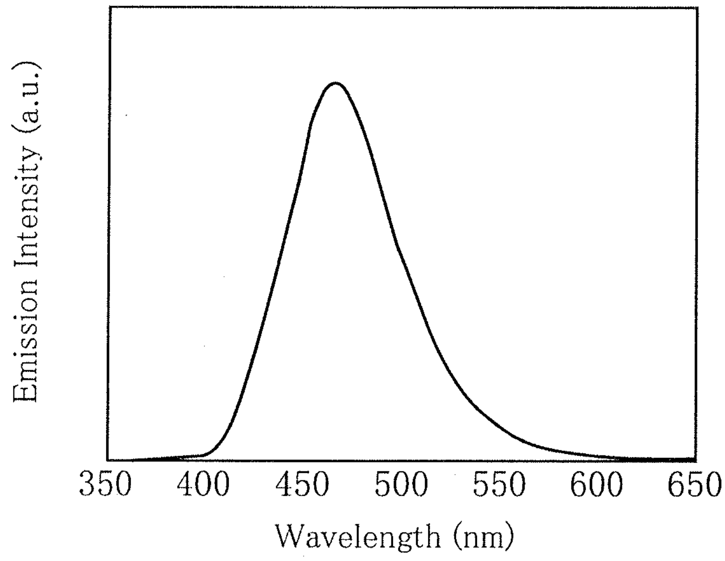
Emission Intensity (a.u.)
350
400
450
500
550
600
650
Wavelength (nm)

FIG.15

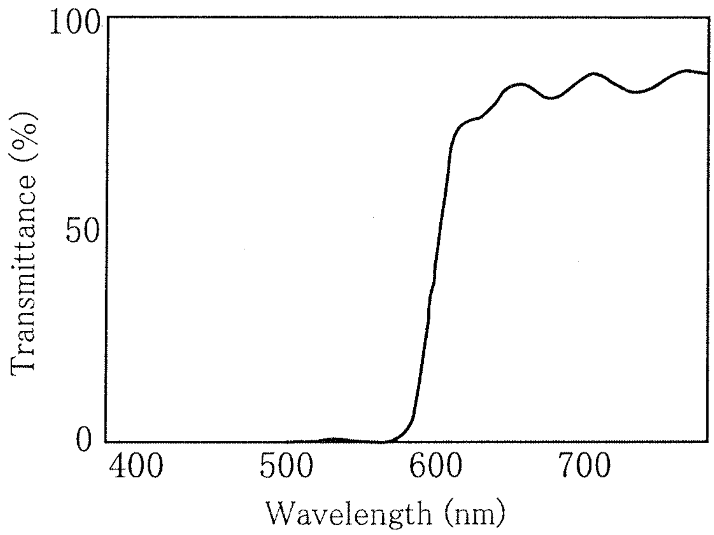
100
50
0
Transmittance (%)
400
500
600
700
Wavelength (nm)

**INTERNATIONAL SEARCH REPORT**

International application No.
PCT/JP2006/304941

A. CLASSIFICATION OF SUBJECT MATTER
*H05B33/12*(2006.01), *H01L33/00*(2006.01), *H01L51/50*(2006.01)

According to International Patent Classification (IPC) or to both national classification and IPC

B. FIELDS SEARCHED

Minimum documentation searched (classification system followed by classification symbols)
*H05B33/12*(2006.01), *H01L33/00*(2006.01), *H01L51/50*(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2000-230172 A (Sharp Corp.),<br>22 August, 2000 (22.08.00),<br>Figs. 2, 11; Par. Nos. [0009] to [0010], [0016] to [0024], [0026] to [0027], [0031] to [0032], [0034] to [0036], [0042] to [0043]<br>(Family: none) | 1,5-9,11<br>2-4,10 |
| Y<br>A | JP 2001-164245 A (Idemitsu Kosan Co., Ltd.),<br>19 June, 2001 (19.06.01),<br>Par. Nos. [0005], [0022], [0025]<br>(Family: none) | 2,10<br>1,3-9,11 |
| Y<br>A | JP 2003-204085 A (Sanyurekku Kabushiki Kaisha),<br>18 July, 2003 (18.07.03),<br>Claims 1 to 4<br>& WO 2003/038915 A1 & TW 000565956 B | 2<br>1,3-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 May, 2006 (22.05.06) | 06 June, 2006 (06.06.06) |
| Name and mailing address of the ISA/<br>Japanese Patent Office<br>Facsimile No. | Authorized officer<br><br>Telephone No. |

Form PCT/ISA/210 (second sheet) (April 2005)

**INTERNATIONAL SEARCH REPORT**

International application No.
PCT/JP2006/304941

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2000-091071 A (Fuji Electric Co., Ltd.), 31 March, 2000 (31.03.00), Par. No. [0009]<br>& US 006249372 B1 & GB 002341486 A | 3<br>1-2,4-11 |
| Y<br>A | JP 8-286033 A (Idemitsu Kosan Co., Ltd.), 01 November, 1996 (01.11.96), Par. Nos. [0006] to [0010]<br>& US 006221517 A & US 2001/0007412 A1<br>& EP 000879867 A1 & WO 1997/029163 A1<br>& DE 069632484 T & CN 001209157 A | 3<br>1-2,4-11 |
| Y<br>A | JP 2004-311153 A (Nitto Denko Corp.), 04 November, 2004 (04.11.04), Full text<br>& US 2004/0212296 A1 | 6<br>1-5,7-11 |
| Y<br>A | JP 2005-071972 A (Akiyoshi MIKAMI), 17 March, 2005 (17.03.05), Fig. 4; Par. Nos. [0019] to [0021]<br>(Family: none) | 8<br>1-7,9-11 |
| Y<br>A | JP 2002-317175 A (Mitsui Chemicals, Inc.), 31 October, 2002 (31.10.02), Full text<br>(Family: none) | 10<br>1-9,11 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 63018319 B
- JP H3152897 A
- WO 9729163 A
- JP H7268010 A

### Non-patent literature cited in the description

- *Materials Science and Engineering,* 1999, vol. B59, 390
- *Appl. Phys. Lett.,* 2002, vol. 80, 3470